Europäisches Patentamt

European Patent Office

Office européen des brevets

(19)

(11) Veröffentlichungsnummer : **0 165 258 B2**

(12) **NEUE EUROPÄISCHE PATENTSCHRIFT**

(45) Veröffentlichungstag der neuen Patentschrift :
23.10.91 Patentblatt 91/43

(51) Int. Cl.$^5$ : **G01R 33/04**

(21) Anmeldenummer : **84904105.8**

(22) Anmeldetag : **14.11.84**

(86) Internationale Anmeldenummer :
**PCT/DE84/00244**

(87) Internationale Veröffentlichungsnummer :
**WO 85/02912 04.07.85 Gazette 85/15**

(54) **MAGNETOMETER MIT ZEITVERSCHLÜSSELUNG.**

(30) Priorität : **17.12.83 DE 3345713**

(43) Veröffentlichungstag der Anmeldung :
**27.12.85 Patentblatt 85/52**

(45) Bekanntmachung des Hinweises auf die
Patenterteilung :
**08.06.88 Patentblatt 88/23**

(45) Bekanntmachung des Hinweises auf die
Entscheidung über den Einspruch :
**23.10.91 Patentblatt 91/43**

(84) Benannte Vertragsstaaten :
**DE FR SE**

(56) Entgegenhaltungen :
EP-A- 0 111 265
DE-A- 2 547 254
DE-A- 2 949 815
DE-B- 2 550 060
US-A- 3 461 382
US-A- 3 568 052
US-A- 4 290 018

(73) Patentinhaber : **ROBERT BOSCH GMBH**
**Robert-Bosch-Platz 1**
**W-7016 Gerlingen-Schillerhöhe (DE)**

(72) Erfinder : **BAUER, Harald**
**Chamerstrasse 25**
**W-8500 Nürnberg (DE)**

EP 0 165 258 B2

## Beschreibung

### Stand der Technik

Die Erfindung geht aus von einem Magnetometer zur Messung von gleichförmigen Magnetfeldern mit einer Zeitverschlüsselung nach dem Oberbegriff des Patentanspruchs 1 gemäß der US-A-4 290 018.

Zur Messung von planetaren Magnetfeldern ist es aus der DE-C-1 623 577 bekannt, Magnetometer mit einer Zeitverschlüsselung zu verwenden. Das Magnetometer enthält eine Sonde mit einem magnetisierbaren stabförmigen Kern, auf dem zwei Wicklungen angeordnet sind. Die eine Wicklung dient zur Erzeugung eines Hilfswechselfeldes, in dem sie an eine Wechselspannung angeschlossen wird, durch die der Kern wechselweise bis in die Sättigung magnetisiert wird. An der anderen Wicklung wird eine Meßspannung abgenommen, die zur Ermittlung des zu messenden Magnetfeldes dient. Dazu wird die Meßspannung mit einem RC-Glied differenziert. Durch das zu messende, in Richtung der Sondenachse wirkende Magnetfeld wird eine zeitliche Verschiebung der Extremwerte der differenzierten Meßspannung bewirkt, wobei das Maß der Verschiebung ein Maß für die Stärke des gemessenen Magnetfeldes bildet. Über einen Komparator kann die differenzierte Meßspannung in einen der Stärke des Magnetfeldes entsprechenden Digitalwert umgeformt werden. Diese Lösung hat jedoch den Nachteil, daß mit dem RC-Glied und dem Komparator die Auswerteschaltung relativ aufwendig ist. Außerdem wird durch das RC-Glied eine Dämpfung der auszuwertenden Signalspannung verursacht und die Meßgenauigkeit wird durch die temperaturabhängige Kapazität des RC-Gliedes beeinflußt.

Ähnliche Nachteile treten auch bei der Magnetfeldmessung nach der US-A-4 290 018 auf. Auch dort enthält das Magnetometer eine Sonde mit einem magnetisierbaren stabförmigen Kern, auf dem eine Wicklung zur Erzeugung des Hilfswechselfeldes und eine weitere zur Erzeugung der Meßspanung angeordnet ist. Die Meßspannung wird dort mit einer aufwendigen Schaltungsanordnung zunächst gleichgerichtet und dann durch einen Komparatorverstärker in Signalpausen umgesetzt, wobei die Ausgangsspannung des Komparatorverstärkers einer Sample and Hold-Schaltung zugeführt wird. Diese Schaltung enthält außerdem zur Bildung von Mittelwerten mehrere Kondensatorstufen, die abhängig von einer Hilfswechselspannung und der Meßspannung aufgeladen bzw. entladen werden. Am Ausgang dieser aufwendigen Auswerteschaltung tritt ein dem gemessenen Magnetfeld entsprechendes Gleichspannungssignal auf, das sich ohne weitere Umformerstufen für eine Auswertung durch einen Rechner nicht verwenden läßt.

Aus der US-A-3 461 382 ist schließlich eine Schaltungsanordnung zur Messung von Magnetfeldern bekannt, bei der ein Magnetometer mit einer Feldmeßsonde einen stabförmigen Kern aufweist, der eine Wicklung zur Erzeugung des Hilfswechselfeldes mit einer überlagerten Meßspannung sowie eine Rückkopplungsspule aufweist, die ein dem gemessenen Magnetfeld entsprechendes Gegenfeld erzeugt. Bei dieser bekannten Lösung werden in ebenso aufwendiger Weise die positiven und negativen Halbwellen der Hilfsund Meßspannung über Gleichrichterstufen, Schwellwertschaltern und logischen Gattern einem Differential-Integrator zur Mittelwertbildung zugeführt, der temperaturabhängige Kondensatoren enthält. Damit treten auch dort die vorerwähnten Nachteile auf.

Aus der DE-AS 25 50 060 ist ein Verfahren bzw. eine Einrichtung zur Detektion eines durch Vormagnetisierung eines Magnetkreises erzeugten Magnetfeldes bekannt. Das Verfahren bzw. die Vorrichtung ist insbesondere auf die Detektion eines Magnetfeldes anwendbar, das durch einen Stromfluß in einem mit dem Magnetkreis gekoppelten Leiter erzeugt wird. Zur Detektion des Magnetfeldes wird ein Ringkern mit einer Detektionsspule verwendet, der um den Leiter gelegt ist. Durch Erregung der Detektionsspule mittels einer Spannungsquelle mit Polaritätsumschalter wird eine zeitlich zyklisch veränderliche Detektions-Stromdurchflutung erzeugt, die proportional zum Strom im Detektionsstromkreis ist. Das detektierte Stromsignal wird über einen Grenzwertschalter geleitet, der die Spannungsquelle bei Überschreiten von vorgegebenen Maximalwerten zyklisch umpolt, so daß die Spannungsquelle positive und negative rechteckförmige Spannungsimpulse abgibt. Mittels eines weiteren Grenzwertschalters wird beim Nulldurchgang des Detektionsstroms ein zur Nullinie symmetrisches Rechtecksignal erzeugt, dessen Tastverhältnis ein Maß für die Stärke der zu detektierenden Vormagnetisierung ist.

Der Erfindung liegt die Aufgabe zugrunde, bei einem Magnetometer der eingangs genannten Art mit einer möglichst einfachen, zuverlässigen und temperaturstabilen Auswerteschaltung ein digitales Meßsignal zu erhalten, das ohne zusätzliche Maßnahmen einem Rechner zur weiteren Auswertung zugeführt werden kann.

Diese Aufgabe ist durch die Merkmale des Patentanspruchs 1 gelöst.

### Vorteile der Erfindung

Das erfindungsgemäße Magnetometer hat den Vorteil, daß die Meßspannung ohne Bedämpfung durch ein RC-Glied vom Schwellwertschalter unmittelbar in ein pulslängenmoduliertes Rechtecksignal umgewandelt wird, wobei ein linearer Zusammenhang zwischen dem Tastverhältnis des Rechtecksignals am Schaltungsausgang und dem gemessenen Magnetfeld entsteht. Als weiterer Vorteil ist anzusehen, daß durch die Verwendung des Schwellwertschaltes die Meßspannung keine ausgeprägten Extremwerte aufweisen muß, wodurch ferner die Anforderungen im Hinblick auf die Form und die Eigenschaften des Sondenkernes größere Toleranzen erlauben.

Durch die in den Unteransprüchen aufgeführten Maßnahmen sind vorteilhafte Weiterbildungen und Verbesserungen der im Hauptanspruch angegebenen Merkmale möglich. Besonders vorteilhaft ist, wenn der Schwellwertschalter aus einem Schmitt-Trigger mit zueinander symmetrischen Schaltschwellen besteht. Eine besonders einfache Lösung läßt sich dadurch realisieren, daß zur Erzeugung des Hilfswechselfeldes und zur Erzeugung der Meßspannung an der Sonde nur eine auf dem Kern angeordnete Wicklung dient. Dabei wird zur Erzeugung des Hilfswechselfeldes ein Dreieckgenerator über eine nachgeschaltete, von der Spannung des Dreieckgenerators gesteuerte Stromquelle mit der Wicklung verbunden, wobei ein Anschluß des Dreieckgenerators und der Wicklung auf ein Bezugspotential liegt. Zur Verstärkung der in der Wicklung induzierten Meßspannung wird das nicht auf Bezugspotential liegende Ende der Wicklung mit dem einen Eingang und er nicht auf Bezugspotential liegende Ausgang des Dreieckgenerators mit dem anderen Eingang eines Subtrahierverstärkers verbunden. Der Ausgang des Subtrahierverstärkers ist sodann unmittelbar mit dem Eingang des Schmitt-Triggers verbunden.

## Zeichnung

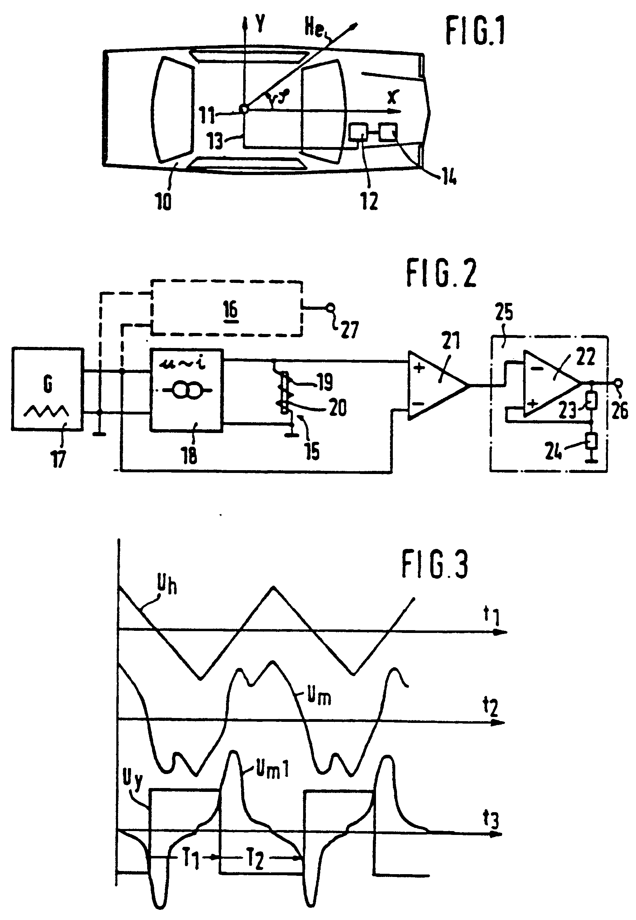

Ein Ausführungsbeispiel der Erfindung ist in der Zeichnung dargestellt und in der nachfolgenden Beschreibung näher erläutert. Es zeigen Figur 1 ein Kraftfahrzeug, bei dem durch einen elektronischen Kompaß mit einem Magnetometer die Fahrrichtung durch Messen des Erdfeldes ermittelt wird, Figur 2 zeigt die Schaltung eines Magnetometers zur Messung einer von einer Sonde erfaßten Magnetfeldkomponente und Figur 3 zeigt den Spannungsverlauf in verschiedenen Punkten der Schaltung nach Figur 2.

## Beschreibung des Ausführungsbeispieles

In Figur 1 ist ein Kraftfahrzeug in der Draufsicht dargestellt und mit 10 bezeichnet. Zur Bestimmung der Fahrrichtung ist das Kraftfahrzeug 10 mit einem elektronischen Kompaß ausgerüstet, der aus einem Magnetometer 11 und einer Auswerteschaltung 12 besteht. Das Magnetometer ist unter dem ach des Kraftfahrzeuges 10 etwa in der Fahrzeugmitte angeordnet und über ein Kabel 13 mit der im Cockpit des Fahrzeuges 10 untergebrachten Auswerteschaltung 12 verbunden. Die mit einem Rechner versehene Auswerteschaltung 12 ist an eine optische Anzeige 14 angeschlossen, die dem Fahrer die augenblickliche Fahrrichtung oder ggf. die einzuschlagende Richtung angibt, um ein zuvor eingegebenes Ziel zu erreichen. Das Magnetometer 11 dient zur Messung der Richtung des Erdfeldes in Bezug auf die Längsachse des Kraftfahrzeuges 10. Zu diesem Zweck ist das Magnetometer 11 mit zwei waagerecht angeordneten, um 90° gegeneinander versetzten Sonden ausgerüstet, von denen eine in Figur 2 dargestellt ist. Die eine der beiden Sonden liegt auf der X-Achse und damit in Richtung der Längsachse des Kraftfahrzeuges 10, während die andere Sonde quer dazu in Richtung der Y-Achse liegt. Der Vektor des Erdfeldes He bildet mit der X-Achse einen Winkel φ. Zur Ermittlung dieses Winkels werden in den beiden Sonden des Magnetometers 11 jeweils die X-Komponente bzw. die Y-Komponente des Erdfeldes He gemessen und die entsprechenden Meßwerte werden der Auswerteschaltung 12 zugeführt, in der in an sich bekannter Weise durch den Rechner der Winkel φ berechnet sowie die Fahrrichtung bzw. die Abweichung der Fahrrichtung von der Richtung zum vorgegebenen Ziel ermittelt werden kann.

Figur 2 zeigt den Schaltungsaufbau des Magnetometers 11, wobei der Schaltungszweig mit der in Richtung der Y-Achse liegenden Sonde 15 im einzelnen dargestellt und im folgenden näher erläutert wird. Der in gleicher Weise aufgebaute Schaltungszweig für die in Richtung der X-Achse liegende Sonde ist der Einfachheit halber gestrichelt als Schaltungsblock 18 dargestellt. Beide Schaltungszweige werden von einem Dreiecksgenerator 17 versorgt, an dessen Ausgang eine in Figur 3 dargestellte Hilfswechselspannung Uh mit einer Amplitude von 500 mV und einer Frequenz von f = 1 kHz auftritt. Der Ausgang des Dreieckgenerators 17 ist mit dem Eingang einer spannungsgesteuerten Stromquelle 18 verbunden, wobei ein Anschluß auf Massepotential liegt. Der Ausgang der Stromquelle 18 ist an eine Wicklung 19 angeschlossen, die auf einem hochpermeablen, stabförmigen Kern 20 der Sonde 15 angeordnet ist. Die Wicklung 19 liegt ebenfalls mit einem Ende auf Massepotential. Das andere Ende der Wicklung 19 liegt ferner am Plus-Eingang eines Subtrahierverstärkers 21, dessen Minus-Eingang mit dem nicht auf Masse liegenden Ausgang des Dreieckgenerators 17 verbunden ist. Der Ausgang des Subtrahierverstärkers 21 ist mit dem Eingang eines Schwellwertschalters verbunden, der aus einem Schmitt-Trigger 25. mit zueinander symmetrischen Schaltschwellen besteht. Der Schmitt-Trigger wird aus einem Operationsverstärkers 22 gebildet, dessen Minus-Eingang mit dem Ausgang des Subtrahierverstärkers 21 und dessen Plus-Eingang mit dem Abgriff eines Spannungsteilers aus den Widerständen 23 und 24 verbunden ist und der zwischen dem Ausgang des Operationsverstärkers 22 und dem Massepotential liegt. Der Schaltungsblock 16 enthält für die in X-Richtung liegende, nicht dargestellte Sonde ebenfalls eine spannungsgesteuerte Stromquelle 18, einen Subtrahierverstärker 21 und einen Schmitt-Trigger 25 in entsprechender Schaltung. Die Ausgäne 26 und 27 der Schaltungsanordnung sind über das Kabel 13 mit der Auswerteschaltung 12, 14 (Figur 1) zu verbinden.

Die Funktionsweise des Magnetometers 11 soll nun mit Hilfe der in Figur 3 dargestellten Spannungsverläufe näher erläutert werden. Die am Ausgang des Dreieckgenerators 17 auftretende Hilfswechselspannung Uh ist auf der Zeitachse t1 aufgetragen. Sie steuert die Stromquelle 18 in der Weise daß in der an ihrem Ausgang angeschlossenen Wicklung 19 ein entsprechend dreieckförmig verlaufender Hilfwechselstrom auftritt, der in dem magnetisierbaren Kern 20 der Sonde 15 ein Hilfswechselfeld erzeugt. Durch dieses Hilfswechselfeld wird der Kern 20 wechselweise, d.h. in wechselnder Richtung bis in die Sättigung magnetisiert. Da der Kern 20 außerdem von der Y-Komponente des Erdfeldes He (Figur 1) durchsetzt wird, überlagern sich beide Felder im Kern 20. Die Y-Komponente des Erdfeldes He bildet dabei das mit der Sonde 15 zu messende Magnetfeld, das den Kern 20 nur in einer Richtung durchsetzt und dadurch den Kern 20 in einer Magnetisierungsrichtung früher in den Sättigungsbereich bringt, die Sättigung dagegen in der entgegengesetzten Magnetisierungsrichtung venögert. Das zu messende Magnetfeld und das vom Wechselstrom erzeugte Hilfswechselfeld erzeugen zusammen mit der angelegten, den Magnetisierungsstrom treibenden Spannung an der Wicklung 19 eine Meßspannung Um, die in Figur 3 auf der Zeitachse t2 dargestellt ist. Durch den Subtrahierverstärker 21 wird nun die Hilfswechselspannung Uh des Dreieckgenerators 17 von der Meßspannung Um in dem Maße subtrahiert, daß am Ausgang des Subtrahierverstärkers 21 nunmehr die auf der Zeitachse t3 dargestellte verstärkte Meßspannung Um1 auftritt, die der vom gesamten Magnetfeld in der Wicklung 19 induzierten Spannung entspricht. Die positiven und negativen Halbwellen der Meßspannung Um an der Wicklung 19 bzw. der verstärkten Meßspannung Um1 am Ausgang des Subtrahierverstärkers 21 weichen in Abhängigkeit von dem zu messenden Magnetfeld voneinander ab. Die Größe der Abweichung ist dabei ein Maß für die Größe des gemessenen Magnetfeldes an der Sonde 15 und folglich ein Maß für die Y-Komponente des Erdfeldes He. Zur Erfassung dieser Abweichung zwischen der positiven und negativen Halbwellen wird die verstärkte Meßspannung Um1 am Ausgang des Subtrahierverstärkers 21 auf den Eingang des Schmitt-Triggers 25 gelegt. Die dadurch am Ausgang 28 erzeugte rechteckförmige, auf der Zeitachse t3 dargestellte Ausgangsspannung Uy wird der Auswerteschaltung 12 (Figur 1) zugeführt, wobei das Tastverhältnis der Rechteckspannung, d.h. die Zeitdauer T1 der positiven Amplitude zur Zeitdauer T2 der negativen Amplitude ein Maß für die Größe der Y-komponente des Erdfeldes He darstellt. Das Tastverhältnis T1/(T1 + T2) wird dabei von dem Rechner, vorzugsweise ein Mikrocomputer der Auswerteschaltung 12 ermittelt und weiter verarbeitet bzw. gespeichert.

In gleicher Weise wird im Schaltungsblock 18 die X-Komponente des Erdfeldes He ermittelt und über den Ausgang 27 in Form einer pulslängenmodulierten Rechteckspannung mit einem der X-Komponente des Erdfeldes entsprechenden Tastverhältnis der Auswerteschaltung 12 (Figur 1) zugeführt. Liegt das zu ermittelnde Erdfeld genau in Fahrrichtung, also in Richtung der X-Achse oder quer dazu, also in Richtung der Y-Achse, so wird nur an einer Sonde das Magnetfeld gemessen. An der anderen Sonde ist die Magnetfeldkomponente gleich Null. Demzufolge wird an dieser Sonde eine Meßspannung mit genau gleichen positiven und negativen Halbwellen erzeugt und demzufolge wird das Tastverhältnis der ihm zugeordneten Ausgangsspannung Uy bzw. Ux gleich 50 %.

Zur Realisierung der Schaltung nach Figur 2 können für den Dreieckgenerator 17 die spannungsgesteuerte Stromquelle 18 sowie für den Subtrahierverstärker 21 und den Schmitt-Trigger 25 Operationsverstärker verwerden, die mit einer stabilisierten Gleichspannung zu versorgen sind. Diese Versorgungsspannung kann ebenfalls über die Leitung 13 geführt werden. Im Rahmen der Erfindung ist es auch möglich, für die beiden um 90° gegeneinander verdrehten Sonden des Magnetometers 11 nur eine spannungsgesteuerte Stromquelle 18 sowie einen Subtrahierverstärker 21 und nur einen Schmitt-Trigger 25 vorzusehen. In diesem Fall muß der Ausgang der Stromquelle 18 sowie der Plus-Eingang des Subtrahierverstärkers 21 in festen Zeitabständen jeweils von der einen Sonde auf die andere umgeschaltet werden. Ebenso ist es aber auch möglich, lediglich die Ausgänge der Subtrahierverstärker 21 durch ständiges Umschalten auf einen gemeinsamen Schmitt-Trigger zu legen. In beiden Fällen ist nur eine Signalleitung von Magnetometer 11 zur Auswerteschaltung 12 erforderlich, die dann synchron zum Magnetometer 11 umgeschaltet, werden muß. Im Rahmen der Erfindung ist es aber ebenso möglich, das Magnetometer 11 mit der Auwerteschaltung 12 und dem Anzeigegerät 13 räumlich zu einem elektronischen Kompaß zusammenzufassen. Andererseits können auch die beiden Sonden an einen geeigneten Ort im Kraftfahrzeug z. B. unter dem Heckfenster, separat von der übrigen Elektronik angeordnet werden. Schließlich kann ein elektronischer Kompaß auch mit nur einer Sonde 15 betrieben werden. In diesem Fall wird die Richtung des Erdfeldes und damit die Richtung Nordpoles dadurch ermittelt, daß der Sensor 15 mit dem waagerecht angeordneten magnetisierbaren Kern 20 soweit gedreht wird, bis das zu messende Magnetfeld einen maximalen Meßwert abgibt. Darüber hinaus kann das Magnetometer ganz allgemein zur Messung magnetischer Felder verwendet werden, sofern es sich dabei um Gleichfelder oder niederfrequente Wechselfelder handelt, die während der Messung weder ihre Richtung noch ihre Stärke ändern. In diesem Fall ist auch eine den Schmitt-Trigger 25 nachgeschaltete Auswertestufe zur Ermittlung des Tastverhältnisses der Rechteckspannung und gegebenenfalls eine Anzeigevorrichtung im Magnetometer mit integriert.

Es sei schließlich darauf hingewiesen daß die Meßansordnung Gegenstand der parallelen zeitgleichen Anmeldung WO 85/02 911 ist.

## Patentansprüche

1. Magnetometer zur Messung von gleichförmigen Magnetfeldern mit einer Zeitverschlüsselung, bestehend aus mindestens einer Sonde (15) mit einem magnetisierbaren Kern (20) und mit einer darauf angeordneten Wicklung (19), die von einem Wechselstrom zur Erzeugung eines Hilfswechselfeldes durchflossen ist, welches den Kern wechselweise bis in die Sättigung magnetisiert und zusammen mit dem zu messenden Magnetfeld eine Meßspannung erzeugt, deren positive und negative Halbwellen in Abhängigkeit von dem zu messenden Magnetfeld voneinander abweichen und einer Auswerteschaltung zur Bestimmung der Größe und Richtung des Magnetfeldes zugeführt werden, dadurch gekennzeichnet, daß der magnetisierbare Kern (20) stabförmig ist, daß zur Erzeugung des Hilfswechselfeldes ein Dreieckgenerator (17) vorgesehen ist, der über eine nachgeschaltete, von der Spannung (Ua) des Dreieckgenerators (17) gesteuerte Stromquelle (18) mit der auf dem Kern (20) angeordneten Wicklung (19) verbunden ist, daß zur Verstärkung der Meßspannung ein Ende der Wicklung (19) mit dem einen Eingang und ein Ausgang des Dreieckgenerators (17) mit dem anderen Eingang eines Subtrahierverstärkers (21) verbunden ist, wobei der andere Ausgang des Dreieckgenerators (17) und das andere Ende der Wicklung (19) auf einem gemeinsamen Bezugspotential liegen, und daß die Meßspannung (Um1), die am Ausgang des Subtrahierverstärkers (21) abgreifbar ist, auf den Eingang eines Schwellwertschalters (25) mit gleich großen, zueinander symmetrischen positiven und negativen Schaltschwellen gelegt ist, dessen Ausgang eine Rechteckspannung (Uy) abgibt, deren Tastverhältnis (T1/(T1 + T2)) ein Maß für die Stärke des vom Kern (20) erfaßten Magnetfeldes bildet.

2. Magnetometer nach Anspruch 1, dadurch gekennzeichnet, daß der Schwellwertschalter (25) als Schmitt-Trigger ausgebildet ist.

3. Magnetometer nach einem der vorhergehenden Ansprüche, dadurch gekennzeichnet, daß der Ausgang des Subtrahierverstärkers (21) mit dem Eingang des Schmitt-Triggers (25) verbunden ist, dessen Ausgang an eine das Tastverhältnis der Ausgangsspannung (Uy) erfassende Auswertestufe (12) angeschlossen ist.

4. Magnetometer nach einem der vorhergehenden Ansprüche, dadurch gekennzeichnet, daß zur Ermittlung der Größe und Richtung des zu messenden Magnetfeldes zwei waagerecht angeordnete, um 90° gegeneinander verdrehte Sonden (15) vorgesehen sind, von denen die eine Sonde jeweils die X-Komponente und die andere die Y-Komponente des Magnetfeldes erfaßt.

## Claims

1. Magnetometer for measuring uniform magnetic fields, with a time coding system consisting of at least one probe (15) having a magnetizable core (20) and with a winding (19) arranged thereon through which an alternating current flows for generating an auxiliary alternating field which alternately magnetizes the core to saturation and, together with the magnetic field to be measured, generates a measurement voltage, the positive and negative half waves of which deviate from one another in dependence on the magnetic field to be measured and are supplied to an evaluating circuit for determining the magnitude and direction of the magnetic field, characterized in that the magnetizable core (20) is rod-shaped, in that, for generating the auxiliary alternating field, a triangular-wave generator (17) is provided which is connected via a subsequent current source (18) controlled by the voltage (Ua) of the triangular-wave generator (17) to the winding (19) arranged on the core (20), in that, for amplifying the measurement voltage, one end of the winding (19) is connected to one input and one output of the triangular-wave generator (17) is connected to the other input of a subtracting amplifier (21), the other output of the triangular-wave generator (17) and the other end of the winding (19) being connected to a common reference potential, and in that the measurement voltage (Um1), which can be picked up at the output of the subtracting amplifier (21), is connected to the input of a threshold switch (25) having positive and negative switching thresholds which are of equal magnitude and are symmetric with respect to one another, the output of which emits a rectangular wave (Uy) the duty ratio (T1/(T1+T2)) of which forms a measure of the intensity of the magnetic field detected by the core (20).

2. Magnetometer according to Claim 1, characterized in that the threshold switch (25) is constructed as a Schmitt trigger.

3. Magnetometer according to any of the preceding claims, characterized in that the output of the subtracting amplifier (21) is connected to the input of the Schmitt trigger (25) the output of which is connected to an evaluating stage (12) which detects the duty ratio of the output voltage (Uy).

4. Magnetometer according to any of the preceding claims, characterized in that, in order to determine the magnitude and direction of the magnetic field to be measured, two horizontally arranged probes (15), rotated by 90° with respect to one another, are provided, one probe of which in each case detects the X component and the other one of which detects the Y component of the magnetic field.

**Revendications**

1. Magnétomètre pour la mesure de champs magnétiques uniformes avec un codage dans le temps, magnétomètre constitué par au moins une sonde (15) avec un noyau magnétisable (20) et avec un enroulement (19) disposé sur ce noyau et qui est parcouru par un courant alternatif pour produire un champ alternatif auxiliaire qui magnétise alternativement le noyau jusqu'à la saturation et engendre conjointement avec le champ magnétique à mesurer une tension de mesure dont les demi-ondes positives et négatives se différencient les unes des autres en fonction du champ magnétique à mesurer et sont appliquées à un circuit d'exploitation pour déterminer la grandeur et la direction de ce champ magnétique à mesurer, magnétomètre caractérisé en ce que : le noyau magnétisable (20) est en forme de barreau, il est prévu pour la production du champ alternatif auxiliaire, un générateur (17) de signaux en dents de scie, qui par l'intermédiaire d'une source de courant (18), branchée à la suite et commandée par la tension (Ua) du générateur (17), est relié à l'enroulement (19) disposé sur le noyau (20), pour l'amplification de la tension de mesure, une extrémité de l'enroulement (19) est reliée à l'une des entrées d'un amplificateur-soustracteur (21) tandis que l'autre entrée de celui-ci est reliée à une sortie du générateur (17) et que l'autre sortie du générateur (17) et l'autre extrémité de l'enroulement (19) sont à un potentiel de référence commun, la tension de mesure (Um1) qui est susceptible d'être prélevée à la sortie de l'amplificateur soustracteur (21), est appliquée à l'entrée d'un commutateur à valeur de seuil (25), avec des seuils de commutation positifs et négatifs de même grandeur, symétriques les uns par rapport aux autres, la sortie de ce commutateur délivrant une tension rectangulaire (Uy) dont le taux d'impulsions (T1/(T1+T2) constitue une mesure de l'intensité du champ magnétique détecté par le noyau (20).

2. Magnétomètre selon la revendication 1, caractérisé en ce que le commutateur à valeur de seuil (25) est réalisé sous la forme d'un déclencheur de Schmitt.

3. Magnétomètre selon une des précédentes revendications, caractérisé en ce que la sortie de l'amplificateur soustracteur (21) est reliée à l'entrée du déclencheur de Schmitt (25), dont la sortie est raccordée à un étage d'exploitation (12) enregistrant le taux d'impulsions de la tension de sortie (Uy).

4. Magnétomètre selon une des précédentes revendications, caractérisé en ce que, pour déterminer la grandeur et la direction du champ magnétique à mesurer, il est prévu deux sondes (15) disposées horizontalement, décalées en rotation de 90° l'une par rapport à l'autre, dont l'une détecte respectivement la composante X et l'autre la composante Y du champ magnétique.

FIG.1

FIG.2

FIG.3